# EUROPEAN PATENT APPLICATION

(11) **EP 4 823 267 A1**
(43) Date of publication of application: **14.10.2026**
(21) Application number: 26152586.9
(22) Date of filing: 19.01.2026
(51) Int. Cl.: H10B 12/00, G11C 8/14, H10D 30/67

(54) **SEMICONDUCTOR DEVICE INCLUDING WORD LINE STRUCTURES**

(30) Priority: 11.04.2025 KR 20250047327
(71) Applicant: SK hynix Inc., Bubal-eub Icheon-si Gyeonggi-do 17336 (KR)
(72) Inventor: OH, Dong Yean, 17336 Icheon-si, Gyeonggi-do (KR); LIM, Myung Soo, 17336 Icheon-si, Gyeonggi-do (KR); CHO, Jin Sun, 17336 Icheon-si, Gyeonggi-do (KR)
(74) Representative: Isarpatent

(57) **Abstract**

A semiconductor device includes a bit line configured to extend in a first direction; a word line structure configured to extend in a second direction, an active region having one side in contact with the bit line and configured to extend in a third direction, and a back gate configured to extend parallel to the word line structure. The word line structure includes a lower word line extending parallel to the back gate, an upper word line spaced apart from the lower word line in the third direction, and a vertical connection portion extending in the third direction while being in contact with both the lower word line and the upper word line.

## Description

### TECHNICAL FIELD

The technology and embodiments disclosed in this patent document generally relate to a semiconductor device, and more particularly to a semiconductor device including a word line structure.

### BACKGROUND

As miniaturization and higher degrees of integration of semiconductor devices have become major priorities, memory cells included in semiconductor devices may be formed to have three-dimensional (3D) patterns. Miniaturized memory cells with three-dimensional (3D) patterns may be equipped with configurations that improve operation characteristics of the memory cells.

### SUMMARY

Various embodiments of the present disclosure relate to a memory device including a word line structure.

In accordance with an embodiment of the present disclosure, a semiconductor device may include a bit line extending in a first direction, a first word line structure extending in a second direction the first direction, an active region having one end in contact with the bit line and extending in a third direction, and a back gate extending parallel to the first word line structure. The first word line structure may include a first lower word line extending parallel to the back gate, a first upper word line spaced apart from the first lower word line in the third direction, and a vertical connection portion extending in the third direction to connect the first lower word line to the first upper word line.

In some embodiments, the semiconductor device may further include a storage element in contact with the other end of the active region.

In some embodiments, the first upper word line may include a material having a resistance less than that of the first lower word line.

In some embodiments, the vertical connection portion may include a material having a resistance less than that of the first lower word line.

In some embodiments, a second word line structure adjacent to the first word line structure in the first direction may include a second upper word line. A level of the first upper word line in the third direction may be different from a level of the second upper word line in the third direction.

In some embodiments, a second word line structure adjacent to the first word line structure may include a second lower word line. A level of the first lower word line in the third direction is the same as a level of the second lower word line in the third direction.

In some embodiments, the back gate may be disposed parallel to side surfaces of a plurality of active regions repeatedly arranged in the second direction.

In some embodiments, the first upper word line may receive an active voltage from a word line driver.

In some embodiments, a second word line structure adjacent in the first direction to the first word line structure may include a second upper word line. The first upper word line may be connected to a first word line driver, and the second upper word line may be connected to a second word line driver.

In some embodiments, the first word line driver and the second word line driver may respectively provide an active voltage to the first and second upper word lines respectively connected to the first word line driver and the second word line driver.

In some embodiments, a width of the first upper word line in the first direction may be greater than a width of the first lower word line in the first direction.

In some embodiments, a thickness of the first upper word line in the third direction may be greater than a thickness of the first lower word line in the third direction.

In accordance with another embodiment of the present disclosure, a semiconductor device may include a plurality of lower word lines repeatedly arranged in a first direction, and extending in a second direction, a plurality of upper word lines configured to respectively overlap the plurality of lower word lines in a vertical direction, and extending in the second direction, a plurality of vertical connection portions configured to connect the plurality of lower word lines to the plurality of upper word lines, a plurality of active regions repeatedly arranged parallel to side surfaces of the plurality of lower word lines, and extending in a third direction, and a plurality of bit lines in contact with the plurality of active regions, wherein some of the plurality of active regions repeatedly arranged in the first direction and commonly in contact with one of the plurality of bit lines.

In some embodiments, the semiconductor device may further include a plurality of storage elements respectively connected to the plurality of active regions.

In some embodiments, upper word lines adjacent to each other in the first direction among the plurality of upper word lines may be disposed at different levels in the third direction.

In some embodiments, the plurality of lower word lines may be disposed at the same level in the third direction.

It is to be understood that both the foregoing general description and the following detailed description of the present disclosure are illustrative and exemplary and are intended to provide further explanation of the disclosure, and that the scope of the present disclosure is not limited to the examples or embodiments described in this specification.

### BRIEF DESCRIPTION OF THE DRAWINGS

The above and other features and beneficial aspects of the present disclosure will become readily apparent with reference to the following detailed description when considered in conjunction with the accompanying drawings.
FIG. 1 is a circuit diagram illustrating an equivalent circuit of a memory cell array according to embodiments of the present disclosure.
FIG. 2 is a perspective view illustrating a portion of a memory cell array according to embodiments of the present disclosure.
FIG. 3 is a cross-sectional view illustrating an example of a memory cell array taken along a line (A-A') of FIG. 2 according to embodiments of the present disclosure.
FIG. 4 is a diagram illustrating a layout structure of a memory cell array of FIG. 2 taken in a third direction according to embodiments of the present disclosure.
FIG. 5 is a diagram illustrating voltage fluctuations of a word line structure according to embodiments of the present disclosure.

### DETAILED DESCRIPTION

The present disclosure provides embodiments and examples of a semiconductor device including a word line structure that may be used in configurations to substantially address one or more technical or engineering issues and to mitigate limitations or disadvantages encountered in semiconductor devices. In recognition of the issues above, embodiments of the present disclosure provide semiconductor devices that are capable of reducing a voltage boosting effect caused by a voltage applied to adjacent word lines. The word line structure according to the embodiments of the present disclosure may include a lower word line, an upper word line, and a vertical connection portion, and may rapidly provide an activation voltage, received through the upper word line, to the lower word line.

Reference will now be made in detail to embodiments of the present disclosure, examples of which are illustrated in the accompanying drawings. Wherever possible, the same reference numbers will be used throughout the drawings to refer to the same or like parts. While the present disclosure is susceptible to various modifications and alternative forms, specific embodiments are shown by way of example in the drawings. However, the present disclosure should not be construed as being limited to the embodiments set forth herein.

Hereinafter, various embodiments will be described with reference to the accompanying drawings. However, it should be understood that the present disclosure is not limited to specific embodiments, but includes various modifications, equivalents and/or alternatives of the embodiments. The embodiments of the present disclosure may provide a variety of effects capable of being directly or indirectly recognized through the present disclosure.

In the following description, a detailed description of related known configurations or functions incorporated herein will be omitted to avoid obscuring the subject matter.

The terminology used herein is for the purpose of describing particular embodiments only and is not intended to be limiting of the present disclosure. As used herein, the singular forms are intended to include the plural forms as well, unless the context clearly indicates otherwise. It will be further understood that the terms "comprises", "includes", "including", and/or "comprising," when used in this specification, specify the presence of stated constituent elements, steps, operations, and/or components, but do not preclude the presence or addition of one or more other constituent elements, steps, operations, and/or components thereof. The term "and/or" may include a combination of a plurality of items or any one of a plurality of items.

Hereinafter, a semiconductor device and a method of manufacturing the same according to embodiments of the present disclosure will be described in detail with reference to the attached drawings.

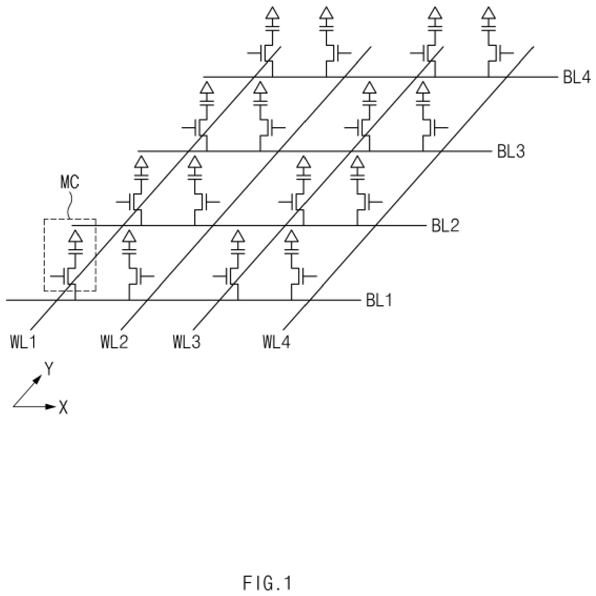

FIG. 1 is a circuit diagram illustrating an equivalent circuit of a memory cell array according to embodiments of the present disclosure.

Referring to FIG. 1, a memory cell array may include a plurality of bit lines BL1, BL2, BL3, and BL4 each extending in a first direction (i.e., an X-axis direction), and a plurality of word line structures WL1, WL2, WL3, and WL4 each extending in a second direction (i.e., a Y-axis direction).

The memory cell array may include a plurality of memory cells MC, each of which may be disposed in a region where a word line and a bit line cross each other.

Each memory cell MC may include a transistor and a storage element. Word line structures may be connected to gates of the transistors included in the memory cells MC, respectively. In addition, one end of the transistor included in the memory cell may be in contact with a bit line and the other end of the transistor included in the memory cell may be in contact with a storage element. The storage element may be, for example, a capacitive element such as a capacitor.

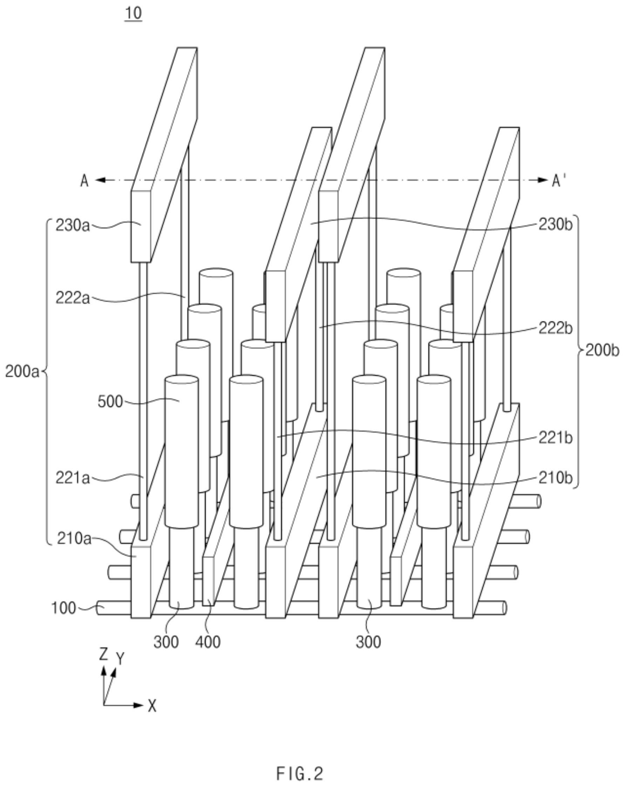

FIG. 2 is a perspective view illustrating a portion of a memory cell array according to embodiments of the present disclosure.

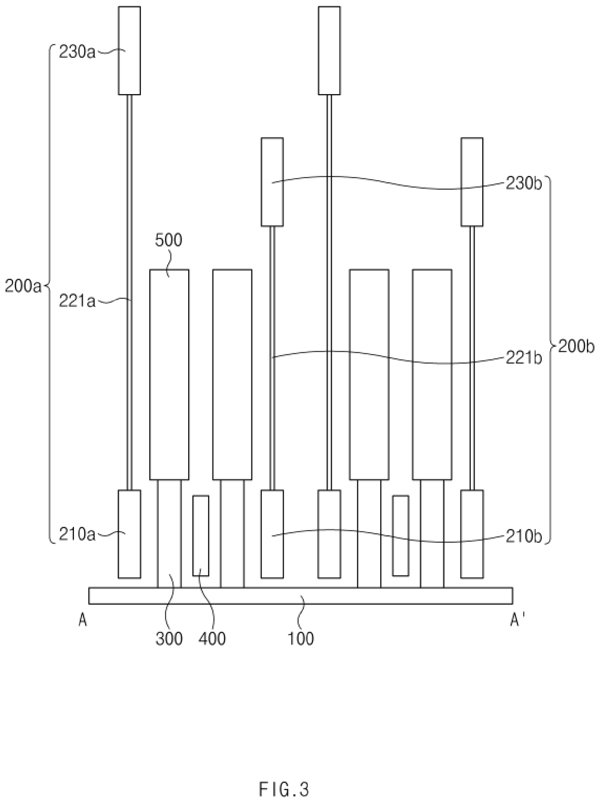

FIG. 3 is a cross-sectional view illustrating an example of a memory cell array taken along a line (A-A') of FIG. 2 according to embodiments of the present disclosure.

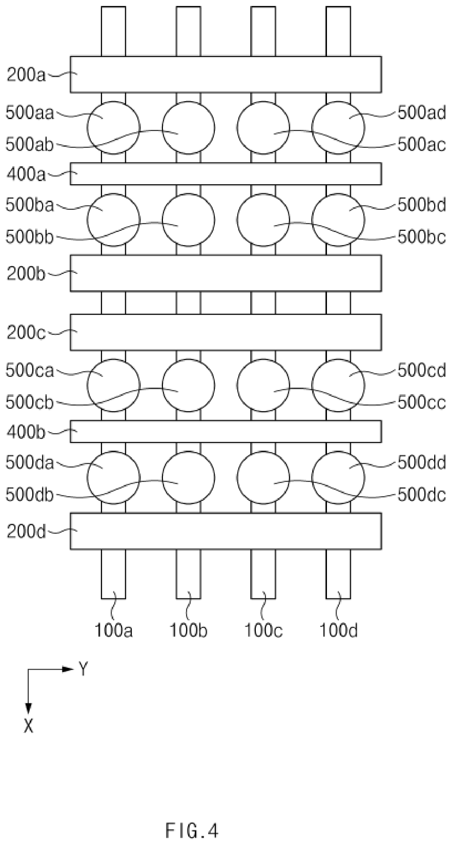

FIG. 4 is a diagram illustrating a layout structure of a memory cell array of FIG. 2 taken in a third direction (i.e., a Z-axis direction) according to embodiments of the present disclosure.

Referring to FIG. 2, a portion 10 of a memory cell array having an equivalent circuit diagram shown in FIG. 1 will hereinafter be described with reference to FIGS. 2 to 4.

The memory cell array may be formed over a substrate (not shown). The substrate may include a semiconductor substrate, for example, a silicon substrate, a germanium substrate, a silicon-germanium substrate, or the like.

Bit lines 100 may be disposed in the substrate (not shown). The bit lines 100 may extend in a first direction (i.e., the X-axis direction), and may be repeatedly arranged in a second direction (i.e., the Y-direction).

Each of the bit lines 100 may include a conductive material. The conductive material may be, for example, any one of a doped semiconductor material, a conductive metal nitride, a metal, and a metal-semiconductor compound.

Word line structures 200a and 200b may be repeatedly arranged in the first direction (i.e., the X-axis direction), and may be spaced apart from the bit lines 100 in the third direction (i.e., the Z-axis direction). The word line structures 200a and 200b may be electrically isolated from the bit lines 100 by an insulation material.

The word line structure 200a may include a lower word line 210a extending in the second direction (i.e., the Y-axis direction), and the word line structure 200b may include a lower word line 210b extending in the second direction.

The word line structure 200a may include an upper word line 230a that overlaps the lower word line 210a in the third direction (i.e., the Z-axis direction) and extends in the second direction. A plurality of vertical connection portions 221a and 222a extend between the upper word line 230a and the lower word line 210a to interconnect the upper word line 230a and the lower word line 210a. The word line structure 200b may include an upper word line 230b that overlaps the lower word line 210b in the third direction and extends in the second direction. A plurality of vertical connection portions 221b and 222b extend between the upper word line 230b and the lower word line 210b to interconnect the upper word line 230b and the lower word line 210b.

The lower word line 210a, the vertical connection portions 221a and 222a, and the upper word lines 230a may include a conductive material. The conductive material may be, for example, any one of a doped semiconductor material, a conductive metal nitride, a metal, or a metal-semiconductor compound. The lower word line 210b, the vertical connection portions 221b and 222b, and the upper word lines 230b may include a conductive material. The conductive material may be, for example, any one of a doped semiconductor material, a conductive metal nitride, a metal, or a metal-semiconductor compound.

The vertical connection portions 221a and 222a and the upper word line 230a may include the same material, and may include a material having a lower resistance than that of the lower word line 210a. The vertical connection portions 221b and 222b and the upper word line 230b may include the same material, and may include a material having a lower resistance than that of the lower word line 210b.

For example, the vertical connection portions 221a, 222a, 221b, and 222b and the upper word lines 230a and 230b may include a metal material such as copper (Cu), while the lower word lines 210a and 210b may include a doped semiconductor material.

The upper word lines 230a and 230b may have higher conductivity than the lower word lines 210a and 210b. In addition, when viewed in the second direction, a cross-sectional area of the upper word line 230a may be greater in size than a cross-sectional area of the lower word line 210a, and a cross-sectional area of the upper word line 230b may be greater in size than a cross-sectional area of the lower word line 210b.

Furthermore, the upper word line 230a may have a greater width in the first direction (i.e., the X-axis direction) than the lower word line 210a. The upper word line 230bmay have a greater width in the first direction (i.e., the X-axis direction) than the lower word line 210b. The upper word line 230a may have a greater thickness in the third direction (i.e., the Z-axis direction) than the lower word line 210a. The upper word line 230b may have a greater thickness in the third direction (i.e., the Z-axis direction) than the lower word line 210b.

For example, the vertical connection portions 221a, 222a, 221b, and 222b may be formed as through-silicon vias (TSVs), respectively. The vertical connection portions 221a and 222a may be arranged at opposite ends of the lower word lines 210a in the second direction (i.e., the Y-axis direction). The vertical connection portions 221b and 222b may be arranged at opposite ends of the lower word lines 210b in the second direction (i.e., the Y-axis direction).

The upper word lines 230a and 230b may be regions that receive an active voltage from a word line driver. The active voltage supplied to the upper word lines 230a and 230b may be provided to the lower word lines 210a and 210b through the vertical connection portions 221a, 222a, 221b, and 222b. For example, the active voltage supplied to the upper word line 230a may be provided to the lower word line 210a through the vertical connection portions 221a and 222a, and the active voltage supplied to the upper word line 230b may be provided to the lower word line 210b through the vertical connection portions 221b and 222b.

When the active voltage is applied to the lower word line 210a, a channel region may be formed within an active region 300 adjacent to the lower word line 210a. When the active voltage is applied to the lower word line 210b, a channel region may be formed within an active region 300 adjacent to the lower word line 210b.

Among the adjacent word line structures 200a and 200b, one word line structure may be referred to as a first word line structure 200a, and the other word line structure may be referred to as a second word line structure 200b.

The first word line structure 200a may include a first lower word line 210a, first vertical connection portions 221a and 222a, and a first upper word line 230a.

The second word line structure 200b may include a second lower word line 210b, second vertical connection portions 221b and 222b, and a second upper word line 230b.

A level of the first upper word line 230a in the third direction (i.e., the Z-axis direction) may be different from a level of the second upper word line 230b in the same direction. Accordingly, the adjacent upper word lines 230a and 230b may be spaced apart from each other in the third direction (i.e., the Z-axis direction).

In addition, the first upper word line 230a and an adjacent second upper word line 230b may be connected to different word line drivers. Each of the upper word lines 230a and 230b may serve as a region that receives a voltage from the word line driver.

Since the upper word lines 230a and 230b are spaced apart from each other, a voltage applied to one upper word line (e.g., 230a) may reduce or minimize a voltage fluctuation generated in the other upper word line (e.g., 230b) adjacent to the one upper word line.

The voltage applied to the first upper word line 230a may be provided to the first lower word line 210a through the first vertical connection portions 221a and 222a. Since the first vertical connection portions 221a and 222a are disposed at both ends of the first lower word line 210a, the voltage applied to the first upper word line 230a may be rapidly transferred to the first lower word line 210a.

Likewise, the voltage applied to the second upper word line 230b may be provided to the second lower word line 210b through the second vertical connection portions 221b and 222b.

As illustrated in FIG. 2, each word line structure (e.g., 200a) is illustratively shown to include two vertical connection portions (e.g., 221a and 222a), but the scope or spirit of the present disclosure is not limited thereto. In other embodiments, each word line structure may further include additional vertical connection portions to facilitate a transfer of voltage from the upper word line 230a to the lower word line 210a. When vertical connection portions are added, the number of voltage transfer paths within the word line structure may increase.

Referring to FIGS. 2 and 3, one side of the active region 300 may be in contact with the bit line 100. The active region 300 may extend from the bit line 100 in the third direction (i.e., the Z-axis direction). The active region 300 may be a region in which a channel is formed. The active region 300 may include, for example, doped polysilicon, undoped polysilicon, amorphous silicon, indium gallium zinc oxide (IGZO), indium zinc oxide (IZO), indium tin oxide (ITO), indium oxide (In₂O₃), etc. The other end of the active region 300 in the third direction may be in contact with the storage element 500.

When an active voltage is applied to the word line structures 200a and 200b adjacent to the active region 300, a channel may be formed in the active region 300.

A plurality of active regions 300 may be arranged in an array shape in the first direction (i.e., the X-axis direction) and the second direction (i.e., the Y-axis direction). The active regions 300 that are repeatedly arranged in the first direction (i.e., the X-axis direction) may be commonly connected to a single bit line 100.

The plurality of active regions 300 that are repeatedly arranged in the second direction (i.e., the Y-axis direction) may be repeatedly arranged parallel and adjacent to the side surfaces of the lower word lines 210a and 210b, respectively.

A back gate 400 included in the word line structures 200a and 200b may extend parallel to the lower word lines 210a and 210b, respectively. The back gate 400 may be disposed parallel and adjacent to the side surfaces of the active regions 300 that are arranged in the second direction (i.e., the Y-axis direction).

Electrical interference may be minimized between the active regions 300 that are adjacent to each other but separated by the back gate 400 interposed therebetween.

The back gate 400 may include a conductive material. The conductive material may be, for example, any one of a doped semiconductor material, a conductive metal nitride, a metal, and a metal-semiconductor compound.

The storage element 500 may be, for example, a capacitive element such as a capacitor. According to another embodiment, the storage element 500 may include a transistor structure.

The storage element 500 may be formed in a pillar shape, for example, a cylindrical shape, a square pillar shape, or a hexagonal columnar shape.

Some of the connection relationships and arrangement structures among the constituent components included in the memory cell array are illustrated in the cross-section of FIG. 3.

Referring to FIG. 3, one end of the active region 300 may be in contact with the bit line 100, and the lower word lines 210a and 210b may be respectively disposed at both sides of the active region 300.

The bit line 100 may be electrically isolated from the back gate 400 and the word line structures 200a and 200b. Although not shown in FIG. 3, an insulation material may be disposed between the bit line 100 and the word line structures 200a and 200b, and an insulation material may also be disposed between the bit line 100 and the back gate 400.

The back gate 400 may be disposed between adjacent active regions 300, and a storage element 500 may be connected to the other end of the active region 300. An insulation material may be disposed between the back gate 400 and the active regions 300 to electrically isolate the active regions 300 from the back gate 400.

The lower word lines 210a and 210b may be respectively connected to the vertical connection portions 221a and 221b, and the vertical connection portions 221a and 221b may be respectively connected to the upper word lines 230a and 230b.

The adjacent upper word lines 230a and 230b may be spaced apart from a storage element 500 in the third direction (i.e., the Z-axis direction).

The storage element 500 may be electrically isolated from the word line structures 200a and 200b.

The adjacent upper word lines 230a and 230b may be disposed at different levels in the third direction (i.e., the Z-axis direction).

The arrangement patterns of some of the word line structures, back gates, and storage elements are illustrated in FIG. 4.

Referring to FIG. 4, a plurality of bit lines 100a, 100b, 100c, and 100d extending in the first direction (i.e., the X-axis direction) may be repeatedly arranged in the second direction (i.e., the Y-axis direction).

A plurality of word line structures 200a, 200b, 200c, and 200d each extending in the second direction (i.e., the Y- axis direction) may be repeatedly arranged in the first direction (i.e., the X-axis direction).

For convenience of description and better understanding of the present disclosure, the bit lines may be referred to as a first bit line 100a, a second bit line 100b, a third bit line 100c, and a fourth bit line 100d, respectively. Likewise, the word line structures may be referred to as a first word line structure 200a, a second word line structure 200b, a third word line structure 200c, and a fourth word line structure 200d, respectively.

One back gate 400a and a plurality of storage elements 500aa, 500ab, 500ac, 500ad, 500ba, 500bb, 500bc, and 500bd may be disposed between a pair of adjacent word lines (e.g., 200a and 200b).

The back gate 400a may be disposed parallel and adjacent to the side surfaces of the plurality of storage elements (e.g., 500aa, 500ab, 500ac, and 500ad) that are repeatedly arranged in the second direction (i.e., the Y-axis direction).

The back gate 400a may be disposed between a pair of storage elements (e.g., 500aa and 500ba) connected to the same bit line (e.g., 100a).

According to an embodiment, the first word line structure 200a and the third word line structure 200c may be connected to a word line driver. In addition, the second word line structure 200b and the fourth word line structure 200d may be connected to another word line driver.

The word line driver connected to the first word line structure 200a and the third word line structure 200c may be referred to as a first word line driver, and the word line driver connected to the second word line structure 200b and the fourth word line structure 200d may be referred to as a second word line driver.

The first word line driver and the second word line driver may provide an active voltage to word lines that are respectively coupled to the first word line driver and the second word line driver. The active voltage is provided to a region such as an upper word line included in each word line structure.

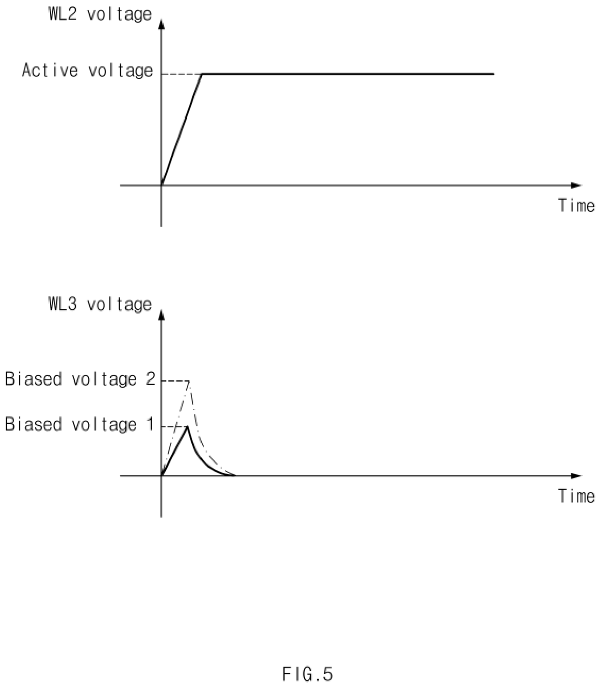

FIG. 5 is a diagram illustrating voltage fluctuations of a word line structure according to embodiments of the present disclosure.

Referring to FIG. 4, a second word line structure WL2 (e.g., 200b of FIG. 4) and a third word line structure WL3 (e.g., 200c of FIG. 4) may be word line structures that are arranged adjacent to each other.

Referring to FIGS. 1 and 5, voltage fluctuations in the third word line structure WL3 may occur due to the active voltage applied to the second word line structure WL2.

When the active voltage is applied to the second word line structure WL2, voltage fluctuations may occur in the third word line structure WL3 adjacent to the second word line structure WL2.

When an active voltage is applied to the second word line structure WL2, electrical interference may occur in the third word line structure WL3 adjacent to the second word line structure WL2. Such electrical interference in the third word line structure WL3 may cause unintended voltage fluctuations within the third word line structure WL3, which may cause data loss in the memory cells.

In a conventional word line structure, the upper word line may not be separately provided, and the active voltage may be directly applied to the lower word line. Adjacent lower word lines may be arranged at the same level in the third direction (i.e., the Z-axis direction). Accordingly, when the active voltage is directly applied to the lower word lines, a large voltage fluctuation may occur in the adjacent word line structures (see "Biased voltage 2" of FIG. 5).

In contrast, the word line structures (e.g., WL2 and WL3) according to embodiments of the present disclosure may be configured such that the upper word lines included in each word line structure may be spaced apart from each other in the third direction (i.e., the Z-axis direction). When the upper word lines to which the active voltage is directly applied are spaced apart from each other in the third direction, smaller voltage fluctuations occur in the adjacent word line structures WL3 (see "Biased voltage 1" of FIG. 5).

As is apparent from the above description, the semiconductor device according to the embodiments of the present disclosure may reduce voltage boosting effects caused by voltage applied to adjacent word lines.

The word line structures according to the embodiments of the present disclosure may each include a lower word line, an upper word line, and a vertical connection portion, and may rapidly provide an activation voltage received in the upper word line to the lower word line.

The embodiments of the present disclosure may provide a variety of effects capable of being directly or indirectly recognized through the above-mentioned patent document.

Those skilled in the art will appreciate that the present disclosure may be carried out in other specific ways than those set forth herein. In addition, claims that are not explicitly presented in the appended claims may be presented in combination as an embodiment or included as a new claim by a subsequent amendment after the application is filed.

Although a number of illustrative embodiments have been described, it should be understood that modifications and enhancements to the disclosed embodiments and other embodiments can be devised based on what is described and/or illustrated in this patent document.

## Claims

1. A semiconductor device comprising:
a bit line extending in a first direction;
a first word line structure extending in a second direction;
an active region having one end in contact with the bit line and extending in a third direction; and
a back gate extending parallel to the first word line structure,
wherein the first word line structure includes:
a first lower word line extending parallel to the back gate;
a first upper word line spaced apart from the first lower word line in the third direction; and
a vertical connection portion extending in the third direction to connect the first lower word line to the first upper word line.

2. The semiconductor device according to claim 1, further comprising:
a storage element in contact with the other end of the active region.

3. The semiconductor device according to claim 1, wherein the first upper word line includes a material having a resistance less than that of the first lower word line.

4. The semiconductor device according to claim 1, wherein the vertical connection portion includes a material having a resistance less than that of the first lower word line.

5. The semiconductor device according to claim 1,
wherein a second word line structure adjacent to the first word line structure in the first direction includes a second upper word line, and
wherein a level of the first upper word line in the third direction is different from a level of the second upper word line in the third direction.

6. The semiconductor device according to claim 1,
wherein a second word line structure adjacent to the first word line structure includes a second lower word line, and
wherein a level of the first lower word line in the third direction is the same as a level of the second lower word line in the third direction.

7. The semiconductor device according to claim 1, wherein the back gate is disposed parallel to side surfaces of a plurality of active regions repeatedly arranged in the second direction.

8. The semiconductor device according to claim 1, wherein the first upper word line receives an active voltage from a word line driver.

9. The semiconductor device according to claim 1,
wherein a second word line structure adjacent in the first direction to the first word line structure includes a second upper word line,
wherein the first upper word line is connected to a first word line driver, and
wherein the second upper word line is connected to a second word line driver.

10. The semiconductor device according to claim 9, wherein the first word line driver and the second word line driver respectively provide an active voltage to the first and second upper word lines respectively connected to the first word line driver and the second word line driver.

11. The semiconductor device according to claim 1, wherein a width of the first upper word line in the first direction is greater than a width of the first lower word line in the first direction.

12. The semiconductor device according to claim 1, wherein a thickness of the first upper word line in the third direction is greater than a thickness of the first lower word line in the third direction.

13. A semiconductor device comprising:
a plurality of lower word lines repeatedly arranged in a first direction, and extending in a second direction;
a plurality of upper word lines respectively overlapping the plurality of lower word lines in a third direction, and extending in the second direction;
a plurality of vertical connection portions connecting the plurality of lower word lines to the plurality of upper word lines;
a plurality of active regions repeatedly arranged parallel to side surfaces of the plurality of lower word lines, and extending in the third direction; and
a plurality of bit lines in contact with the plurality of active regions,
wherein some of the plurality of active regions repeatedly arranged in the first direction and commonly in contact with one of the plurality of bit lines.

14. The semiconductor device according to claim 13, wherein upper word lines adjacent to each other in the first direction among the plurality of upper word lines are disposed at different levels in the third direction.

15. The semiconductor device according to claim 13, wherein the plurality of lower word lines is disposed at the same level in the third direction.
